# EUROPÄISCHE PATENTSCHRIFT

(11) **EP 2 026 376 B1**
(45) Veröffentlichungstag und Bekanntmachung des Hinweises auf die Patenterteilung: **16.10.2013**
(21) Anmeldenummer: 08170189.8
(22) Anmeldetag: 13.08.2000
(51) Int. Cl.: H01J 37/32

(54) **Elektrische Versorgungseinheit für Plasmaanlagen**
Electrical supply unit for plasma systems
Ensemble d'alimentation électrique pour systèmes à plasma

(30) Priorität: 13.08.1999 DE 19937859
(43) Veröffentlichungstag der Anmeldung: 18.02.2009
(62) Teilanmeldung aus: 00965751.1
(73) Patentinhaber: TRUMPF Hüttinger GmbH + Co. KG, 79111 Freiburg im Breisgau (DE)
(72) Erfinder: Zähringer, Gerhard, 79112 Freiburg (DE); Wiedemuth, Peter, 79336 Herbolzheim (DE); Rettich, Thomas, 79108 Freiburg (DE)
(74) Vertreter: Lohr, Georg

(56) Entgegenhaltungen:
- EP-A- 0 592 164
- EP-A- 1 013 792
- WO-A-97/49267
- US-A- 5 303 139
- US-A- 5 682 067
- US-A- 5 889 391

## Beschreibung

### Technisches Gebiet

Die Erfindung bezieht sich auf eine elektrische Versorgungseinheit für Plasmaanlagen, wie Plasma-Bearbeitungs- bzw. Beschichtungsvorrichtungen, bei denen es zum Auftreten von Lichtbögen bzw. Durchschlägen (Arcs) insbesondere zwischen den Elektroden kommen kann, gemäß dem Oberbegriff der unabhängigen Patentansprüche.

Plasmaanlagen, für die die gattungsgemäßen elektrischen Versorgungseinheiten bestimmt sind, haben eine Vielzahl von Anwendungsmöglichkeiten und werden beispielsweise zum Besputtern von Targets eingesetzt. In der Regel haben sie eine elektrische Leistung in der Größenordnung von ca. einigen kW bis zu mehr als 100 kW. Die an die Elektroden angelegte Betriebsspannung liegt dabei typischerweise in der Größenordnung von 400 V. Selbstverständlich sind dabei Abweichungen nach oben oder unten - auch in Abhängigkeit von der Anwendung - möglich.

Insbesondere beim sogenannten "reaktiven" Sputtern, das zum Beispiel zur Herstellung von Oxid- oder Nitrid-Filmen verwendet wird, oder bei der Verwendung reaktiver Gase ergeben sich Probleme durch das Auftreten von Durchschlägen und/oder die Bildung isolierender Schichten auf dem leitenden Target, durch die sich parasitäre Kondensatoren ausbilden können.

### Stand der Technik

Es sind die verschiedensten passiven und aktiven Schaltungen bekannt, die zum Löschen von Lichtbögen dienen, die sich aufgrund von Durchschlägen gebildet haben. Allen diesen Schaltungen ist gemeinsam, daß für einen bestimmten Zeitraum die an die Elektroden angelegte Spannung abgeschaltet wird. Nur exemplarisch wird hierzu auf die US-PSen 4,692,230, 5,009,764, 5,015,493 und 5,682,067 verwiesen.

Die US-PS 5,303,139 beschreibt überdies den Stand der Technik, von dem bei der Formulierung des Oberbegriffs der unabhängigen Patentansprüche ausgegangen worden ist.

Nachteilig bei den bekannten Schaltungen ist, daß nach dem Wiedereinschalten der Betriebsspannung das System eine vergleichsweise lange Zeit benötigt, um wieder mit "voller Leistung sputtern" oder das Target in anderer Weise bearbeiten zu können.

Entsprechendes gilt, wenn das System in einem sogenannten asymmetrischen Pulsbetrieb betrieben wird, um die Bildung von isolierenden Schichten auf dem Target zu verhindern.

Weiterhin ist es bekannt, die an die Elektroden angelegte Spannung periodisch - unabhängig davon ob ein Durchschlag oder ein Lichtbogen auftritt - für einen kurzen Zeitraum abzuschalten. Bei dieser Vorgehensweise muß die Einschaltdauer so gewählt werden, daß während der Zeit, während der die Spannung angelegt ist, kein Durchschlag bzw. kein Lichtbogen auftritt. Damit kann zwar das Auftreten von Durchschlägen bzw. Lichtbögen verhindert werden, durch das periodische Abschalten und das anschließende Wiederanlegen der Spannung wird die Effizienz der Anlage jedoch deutlich reduziert.

### Darstellung der Erfindung

Der Erfindung liegt die Aufgabe zugrunde, eine elektrische Versorgungseinheit für Plasmaanlagen anzugeben, bei der nach dem Wiederanlegen der Betriebsspannung an die Elektroden das System möglichst schnell seine volle Leistung erreicht, und/oder bei der die Effizienzverringerung durch das Auftreten von Lichtbögen bzw. Durchschlägen beispielsweise durch das "prophylaktische" Abschalten der Betriebsspannung möglichst gering ist.

Erfindungsgemäße Lösungen dieser Aufgabe sind in den Patentansprüchen 1 bzw. 10 angegeben. Weiterbildungen der Erfindung sind Gegenstand der abhängigen Ansprüche.

Erfindungsgemäß wird von einer elektrischen Versorgungseinheit ausgegangen, die eine Gleichspannungs- bzw. Gleichstromquelle, deren Ausgangsanschlüsse über wenigstens eine Induktivität und einen Leistungsschalter mit den Elektroden der Plasmaanlage verbunden sind, und gegebenenfalls eine Schaltung zum Erkennen von Lichtbögen bzw. Durchschlägen aufweist, die beim Auftreten eines Lichtbogens bzw. eines Durchschlags den Schalter derart betätigt, daß keine elektrische Energie mehr an die Elektroden angelegt wird.

Weiter ist (sind) die Induktivität(en) jeweils mit einer Freilaufdiode beschaltet , und der Schalter ist ein Serienschalter.

Aufgrund dieser Ausbildung arbeitet die Versorgungseinheit wie folgt:

Der Schalter, der die an die Elektroden angelegte elektrische Leistung schaltet (im folgenden auch als Leistungsschalter bezeichnet), öffnet beim Erkennen eines Lichtbogens den Stromfluß zwischen der Gleichspannungsquelle und den Elektroden. Die Dioden, die bezogen auf die normale Betriebsspannung in Sperrrichtung geschaltet sind, verhindern beim Öffnen des Leistungsschalters, daß die Spannungen an den Induktivitäten ansteigen und bewirken gleichzeitig, daß der Strom in den Induktivitäten nur sehr langsam abnimmt. Wird der Leistungsschalter bereits nach kurzer Zeit - typisch sind etwa einige Millisekunden - wieder eingeschaltet, so steht der in den Induktivitäten gespeicherte Strom sofort zur Verfügung, so daß das System schneller als beim Stand der Technik seine volle Leistung erreicht. Die Versorgungseinheit hat damit beim Wiedereinschalten des Leistungsschalters eine Stromquellencharakteristik.

Damit sind bei der elektrischen Versorgungseinheit die Einbußen in der Leistung aufgrund des Abschaltens der Betriebsspannung zur Löschung von Lichtbögen wesentlich geringer als beim Stand der Technik.

Diese Grundschaltung kann unter verschiedenen Aspekten, die auch miteinander kombiniert werden können, erweitert werden:

Insbesondere ist es möglich, in jeder Leitung, die einen Anschluß der Gleichspannungs- bzw. Gleichstromquelle mit der jeweils zugeordneten Elektrode verbindet, eine Induktivität mit einer zugeordneten Freilaufdiode vorzusehen. Hierdurch erhält man einen besonders symmetrischen Schaltungsaufbau. Es ist jedoch möglich, nur eine Induktivität zu verwenden; in diesem Falle ist auch nur eine Freilaufdiode erforderlich.

Als Schalter können selbstverständlich die unterschiedlichsten Leistungsschalter verwendet werden. Im Hinblick auf die hohe Leistung ist es jedoch bevorzugt, wenn der Schalter ein IGBT ist.

Auch als Netzteil können die unterschiedlichsten Netzteile eingesetzt werden, ebenfalls im Hinblick auf die hohe Leistung ist es jedoch bevorzugt, wenn die Gleichspannungsquelle ein Schaltregler-Netzteil ist.

In diese Falle ist es von Vorteil, wenn zwischen die Anschlüsse der Gleichspannung- bzw. Gleichstromquelle ein Kondensator geschaltet ist. Dieser Kondensator dient zur Vermeidung von Spannungsspitzen, die durch die Zuleitungsinduktivitäten in der Versorgungseinheit auftreten können. Weiterhin wird dieser Kondensator in der Zeit, in der der Leistungsschalter abgeschaltet ist, auf die volle Leerlaufspannung aufgeladen, so daß beim Durchschalten des Leistungsschalters die volle Spannungen zum Zünden des Plasmas zur Verfügung steht.

Die Versorgungseinheit läßt sich für die verschiedensten Plasmaanlagen einsetzen, wie beispielsweise Plasmaanlagen, bei denen die eine Elektrode wenigstens eine in einer Plasmakammer angeordnete Kathode aufweist, und die andere Elektrode das Gehäuse der Plasmakammer ist. Die Versorgungseinheit hat darüberhinaus den besonderen Vorteil, daß es auch für Plasmaanlagen verwendbar ist, bei denen wenigstens zwei voneinander getrennte Kathoden vorgesehen sind, von denen jede über einen Serienschalter mit der mit einer Freilaufdiode beschalteten Induktivität an dem einen Anschluß der Gleichspannungsquelle verbunden ist.

Bei derartigen Systemen kann beispielsweise zwischen den Kathoden alternierend umgeschaltet werden. Dies hat den Vorteil, daß Lichtbögen, die an der einen Kathode "im Entstehen" sind, zuverlässig in dem vergleichsweise langen Zeitraum gelöscht werden, während dem auf die andere Kathode umgeschaltet wird. Selbstverständlich ist es aber auch möglich, gleichzeitig von mehreren Kathoden zu sputtern.

Bei der Erfindung ist zwischen die Elektrodenanschlüsse bzw. die Elektrodenpaare eine Diode geschaltet. Die Funktion dieser Diode wird im folgenden erläutert:

Beim Öffnen des Leistungsschalters polt die Spannung an den Zuleitungsinduktivitäten zur Plasmakammer um, so daß sich ohne weitere Schaltungsmaßnahmen Spannungsspitzen ergeben würden. Die zwischen die Elektrodenanschlüsse geschaltete Diode schließt diese Spannung kurz, so daß die in den Zuleitungsinduktivitäten gespeicherte Energie abgebaut wird.

Weiterhin ist es möglich, ein LC-Glied parallel zu der Diode zu schalten, das als passives Element die Löschung des Lichtbogens unterstützt.

Erfindungsgemäß wird die Löschung des Lichtbogens durch aktive Schaltungselemente unterstützt wird:

Hierzu ist ein Kondensator in Reihe mit der Diode geschaltet. Zwischen Kathodenanschluß und den Verbindungspunkt Diode/Kondensator kann ein weiterer Serienschalter geschaltet sein. Durch diesen Schaltungsaufbau wird die sich aus der Leitungsinduktivität und dem fließenden Strom ergebende Energie beim Öffnen des Leistungsschalters als Spannung in den Kondensator umgeladen. Nach einer kurzen Verzögerung wird diese Spannung über den weiteren Serienschalter an die Elektroden angelegt, so daß der Lichtbogen wesentlich schneller als bei einer passiven Schaltung gelöscht wird.

Um auch bei kleinen Leitungsinduktivitäten oder kleinen Strömen eine entsprechend große invertierte Spannung zum Löschen zu erhalten, kann ferner eine Inversspannungsquelle vorgesehen werden.

Diese Inversspannungsquelle kann insbesondere eine (Hilfs)-Gleichspannungsquelle sein, deren Minuspol mit der Anode und deren Pluspol über eine in Vorwärtsrichtung geschaltete Diode mit dem einen Anschluß des weiteren Serienschalters verbunden ist.

In jedem Falle ist es bevorzugt, wenn die Schaltung zum Erkennen von Lichtbögen außer dem Leistungsschalter auch den weiteren Schalter ansteuert.

Die Schaltung zum Erkennen von Lichtbögen kann dabei wenigstens eines der folgenden Kriterien auswerten:
- Spannungseinbruch,
- Überschreiten der Maximum-Spannungsgrenze,
- Unterschreiten der Minimum-Spannungsgrenze
- Schneller Stromanstieg,
- Überschreiten der Maximum-Stromgrenze.

Weiterhin kann in an sich bekannter Weise eine Steuereinheit, die insbesondere Bestandteil der Schaltung zum Erkennen von Lichtbögen sein kann, vorgesehen sein, die "prophylaktisch" mit einer festen Periode die an die Elektroden angelegte Spannung ab- und bevorzugt umschaltet. Wird die an die Elektroden angelegte Spannung regelmäßig für einen kurzen Moment umgepolt, so kann die Entstehung von Lichtbögen wesentlich verringert werden bzw. können Lichtbögen schon in der Entstehung wieder gelöscht werden.

Aufgrund der Ausbildung, die nach dem Wiederanschalten zu einem schnellen Erreichen der Leistung führt, führt das regelmäßige Umpolen der Spannung nur zu einer sehr geringen Reduzierung der Sputterleistung, sofern die Zeitdauer, während der die an die Elektroden angelegte Spannung umgeschaltet wird, wesentlich kürzer als die Zeitdauer ist, während der ein Plasmabetrieb ausgeführt wird. Weiterhin muß die Zeitdauer, während der die Spannung umgeschaltet wird, natürlich auch so kurz sein, daß der Strom in dem Kreis "Induktivität/Freilaufdiode" gespeichert wird.

Die Frequenz, mit der die Steuereinheit die an die Elektroden angelegte Spannung ab- bzw. umschaltet, kann dabei bis zu 100 kHz betragen.

Anstelle einer periodischen prophylaktischen Umschaltung mit einer festen Periode, die unabhängig von den Prozeßparametern und der hiervon abhängigen Häufigkeit von Lichtbögen bzw. Durchschlägen ist, ist es jedoch bevorzugt, wenn die Steuereinheit in Art einer adaptiven Regelung die Einschaltdauer der Spannung so einstellt, daß "gerade" kein Lichtbogen bzw. Durchschlag auftritt. Dabei ist es von Vorteil, wenn eine Steuer- bzw. Regeleinheit vorgesehen ist, die beim Auftreten eines Lichtbogens bzw. Durchschlags diesen durch Abschalten der an die Elektroden angelegten Spannung oder Umschalten auf eine Inversspannung für eine bestimmte Zeitdauer (Ausschaltdauer) löscht, und daß die Steuer- bzw. Regeleinheit nach dem Auftreten wenigstens eines Lichtbogens bzw. Durchschlags die Einschaltdauer der einen Plasmabetrieb hervorrufenden Spannung verringert.

Dabei ist es von besonderem Vorteil, wenn die Steuer- bzw. Regeleinheit die Einschaltdauer auf eine Zeitdauer verringert, die kleiner als der aktuelle Zeitabstand zwischen zwei nacheinander auftretenden Lichtbögen bzw. Durchschlägen ist. Da sich die Betriebsparameter einer Anlage während eines Bearbeitungsvorgangs ändern können, ist es weiterhin bevorzugt, wenn die Steuer- bzw. Regeleinheit die Einschaltdauer auch vergrößert:

Hierzu ist es beispielsweise möglich, daß die Steuer- und Regeleinheit die Einschaltdauer vergrößert, wenn über einen bestimmten Zeitraum bzw. über eine bestimmte Zahl von Einschaltperioden kein Lichtbogen bzw. Durchschlag oder nur eine bestimmte Zahl von Lichtbögen bzw. Durchschlägen aufgetreten ist. Die Steuer- und Regeleinheit kann die Einschaltdauer dabei bis zum CW-Betrieb verlängern.

Um das zufällige Auftreten von Arcs bei der adaptiven Regelung nicht so stark zu gewichten, ist es ferner bevorzugt, wenn die Steuer- bzw. Regeleinheit die Einschaltdauer nur dann verringert, wenn während einer bestimmten Zeit eine gewisse Zahl von Lichtbögen bzw. Durchschlägen aufgetreten ist.

Weiterhin ist es bevorzugt, wenn die Steuer- bzw. Regeleinheit beim Beginn des Plasmabetriebs die an die Elektroden angelegte Spannung entweder dauernd oder für eine bestimmte (vor Beginn des Prozesses vorgebbare) Einschaltdauer einschaltet, dann für eine bestimmte Ausschaltdauer ab- oder bevorzugt umschaltet, und sodann die Spannung wieder einschaltet, und beim Auftreten von Lichtbögen bzw. Durchschlägen die Einschaltdauer der Spannung verringert.

Um die Versorgungseinheit an die unterschiedlichsten Bearbeitungs- bzw. Aufbringvorgänge anpassen zu können, ist es ferner von Vorteil, wenn die anfänglichen Werte der Einschaltdauer und der Ausschaltdauer und/oder die Zahl von Lichtbögen bzw. Durchschlägen sowie die Zeiteinheit, in denen diese Zahl auftritt, einstellbar sind.

In jedem Falle ist es ferner von Vorteil, wenn die Einschaltdauer mit der Häufigkeit des Auftretens von Lichtbögen bzw. Durchschlägen über eine variable Kennlinie verknüpft ist, die von weiteren Prozeßparametern abhängig sein kann.

Um die Reduzierung der Leistung der Plasmaanlage so gering wie möglich zu halten, ist es ferner von Vorteil, wenn die Steuer- bzw. Regeleinheit die Ausschaltdauer bzw. die Umschaltdauer optimiert. Die Aus- bzw. Umschaltdauer wird dabei "gerade" so lang eingestellt, daß der Lichtbogen bzw. Durchschlag (Arc) "nachhaltig" gelöscht wird.

### Kurze Beschreibung der Zeichnung

Die Erfindung wird nachstehend unter Bezugnahme auf die Zeichnung näher beschrieben, in der zeigen:
- Fig. 1: die Schaltung eines ersten Beispiels, das nicht Bestandteil der beanspruchten Erfindung ist,
- Fig. 2: ein Spannungs/Zeit-Diagramm zur Erläuterung der Funktionsweise der in Fig. 1 gezeigten Schaltung,
- Fig. 3: die Schaltung eines Ausführungsbeispiels der Erfindung,
- Fig. 4: ein Spannungs/Zeit-Diagramm zur Erläuterung der Funktionsweise der in Fig. 3 gezeigten Schaltung,
- Fig. 5: ein Spannungs/Zeit-Diagramm zur Erläuterung der Funktionsweise einer Modifikation der in Fig. 3 gezeigten Schaltung,
- Fig. 6: die Schaltung eines weiteren Beispiels der Erfindung, das ebenfalls nicht Bestandteil der beanspruchten Erfindung ist, und
- Fig. 7: ein Spannungs/Zeit-Diagramm zur Erläuterung der Funktionsweise des in Fig. 6 gezeigten Beispiels, und
- Fig. 8: ein Blockschaltbild eines weiteren Beispiels, das ebenfalls nicht Bestandteil der beanspruchten Erfindung ist, und
- Fig. 9: eine Darstellung zur Erläuterung der Funktionsweise des in Fig. 8 gezeigten Beispiels.

### Darstellung von Ausführungsbeispielen

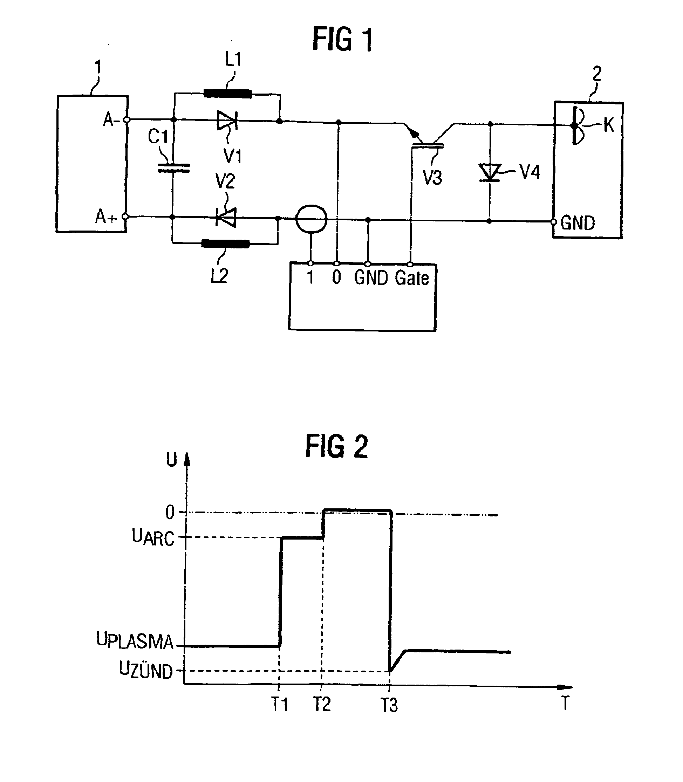

Fig. 1 zeigt ein erstes Beispiel. Die Energieversorgungseinheit weist ein Schaltregler-Netzteil 1 auf, das beispielsweise (d.h. ohne Beschränkung der Allgemeinheit) eine Gleichspannung von ca. 400 V liefert. Der negative Ausgangsanschluß A- des Netzteils 1 ist über eine Induktivität L1 und einen als Serienschalter ausgebildeten Leistungsschalter V3 mit einer Kathode K in einer Plasmakammer 2 verbunden, deren Gehäuse geerdet ist. Der Serienschalter 1 ist bei dem gezeigten Beispiel ein IGBT. Der positive Ausgangsanschluß A+ des Netzteils 1 ist über eine Induktivität L2 mit dem Gehäuse der Plasmakammer 2 verbunden. Dies ist symbolisch mit GND bezeichnet.

Parallel zu den Induktivitäten L1 und L2 sind erfindungsgemäß Dioden V1 bzw. V2 geschaltet, die derart gepolt sind, daß sie beim Plasmabetrieb sperren.

Ferner ist zwischen die Ausgangsanschlüsse A- und A+ ein Kondensator C1 geschaltet. Zwischen den Kathodenanschluß und GND ist eine Diode V4 geschaltet, die beim Plasmabetrieb in Sperrrichtung gepolt ist.

Weiterhin ist eine Schaltung 3 zum Erkennen von Lichtbögen bzw. Durchschlägen vorgesehen, die den Serienschalter V3 über den Ausgangsanschluß "Gate" steuert. Um einen Lichtbogen - auch als Arc bezeichnet - zu erkennen, mißt die Schaltung 3 den fließenden Strom I und die Spannung U und wertet die gemessenen Größen nach folgenden Kriterien aus:
- Spannungseinbruch,
- Überschreiten der Maximum-Spannungsgrenze,
- Unterschreiten der Minimum-Spannungsgrenze
- Schneller Stromanstieg,
- Überschreiten der Maximum-Stromgrenze.

Beim Erkennen eines Lichtbogens wird der Leistungsschalter V3 von der Schaltung 3 geöffnet, so daß der Stromfluß zwischen dem Netzteil 1 und den Elektroden der Plasmakammer 2 unterbrochen wird. Beim Öffnen des Leistungsschalters polt die Spannung an den Zuleitungsinduktivitäten zur Plasmakammer 2 um; um zu vermeiden, daß dies zu Spannungsspitzen führt, werden die Elektroden über die Diode V4 kurzgeschlossen und die in den Zuleitungsinduktivitäten gespeicherte Energie abgebaut.

Die Dioden V1 und V2 verhindern zum einen, daß die Spannungen an den Induktivitäten L1 und L2 beim Öffnen des Leistungsschalters ansteigen und bewirken gleichzeitig, daß der Strom in den Induktivitäten nur sehr langsam abnimmt. Die Induktivitäten L1 und L2 können auch magnetisch gekoppelt sein. Der Kondensator C1 dient zur Vermeidung von Spannungsspitzen, die durch die Zuleitungsinduktivitäten auftreten können.

Im folgenden soll die Funktionsweise der in Fig. 1 gezeigten elektrischen Versorgungseinheit unter Bezugnahme auf Fig. 2, in der ein Spannungs/Zeit-Diagramm dargestellt ist, näher beschrieben werden:

Zum Zeitpunkt T1 bricht die Spannung U aufgrund eines Lichtbogens auf die für einen Lichtbogen bzw. Durchschlag typische Spannung UARC ein. Nach der einstellbaren Verzögerungszeit T1-T2 wird der Schalter V3 geöffnet und die Energiezufuhr unterbrochen. Nach der einstellbaren Lichtbogen-Pause T2-T3 wird der Schalter V3 wieder geschlossen, die Spannung steigt bis auf die Zündspannung UZÜND an und bricht wieder auf die Brennspannung UPLASMA zurück.

Durch die vorgesehenen Freilaufdioden V1 und V2 wird der Generator-Ausgangsstrom zum Zeitpunkt des Abschaltens gespeichert, so daß beim Wiedereinschalten der ursprüngliche Betriebszustand sehr schnell wieder erreicht wird.

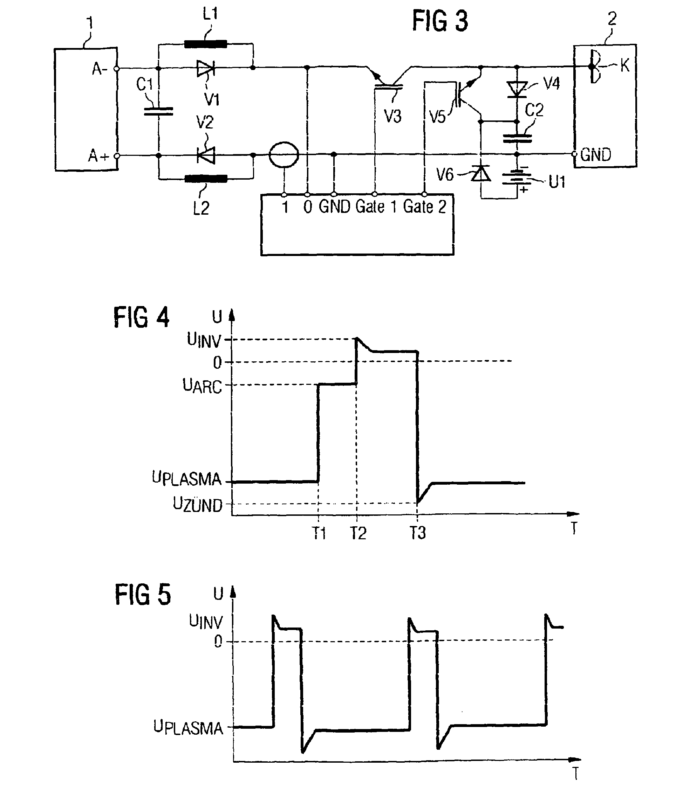

Fig. 3 zeigt eine erfindungsgemäße Modifikation des in Fig. 1 gezeigten Ausführungsbeispiels. Dabei sind gleiche Teile wie in Fig. 1 mit den selben Bezugszeichen versehen, so daß auf eine erneute Vorstellung verzichtet wird.

Bei diesem Ausführungsbeispiel der Erfindung ist in Reihe mit der Diode V4 ein Kondensator C2 geschaltet. Zwischen den Anschluß der Kathode K und den Verbindungspunkt Diode V4/Kondensator C2 ist ein weiterer Serienschalter V5 geschaltet, der ebenfalls von der Schaltung 3 über den Ausgangsanschluß Gate2 angesteuert wird.

Weiterhin kann optional eine Inversspannungsquelle vorgesehen sein, die eine (Hilfs)-Gleichspannungsquelle U1 aufweist, die typischerweise eine Spannung von etwa 30 V liefert. Der Minuspol der Gleichspannungsquelle U1 ist mit der Anode verbunden, während der Pluspol der Gleichspannungsquelle U1 über eine im Vorwärtsrichtung geschaltete Diode V6 mit dem einen Anschluß des weiteren Serienschalters V5 verbunden ist.

Im folgenden wird die Funktionsweise des in Fig. 3 gezeigten Ausführungsbeispiels unter Bezugnahme auf Fig. 4 näher erläutert, die ein Spannungs/ZeitDiagramm zeigt.

Beim Auftreten eines Lichtbogens (Zeitpunkt T1) bricht die Spannung von der Plasma-Spannung UPlasma auf die Lichtbogen-Spannung UArc zusammen. Daraufhin öffnet die Schaltung 3 den Leistungsschalter V3. Durch den mit der Diode V4 in Reihe geschalteten Kondensator C2 wird die sich aus der Leitungsinduktivität und dem Strom ergebende Energie als Spannung in den Kondensator C2 umgeladen. Zum Zeitpunkt T2 wird diese Spannungen als Inversspannung an die Elektroden der Plasmakammer 2 angelegt, so daß der Lichtbogen wesentlich schneller als ohne aktive Löschung gelöscht wird. Durch die optionale Spannungsquelle U1 kann die angelegte Inversspannung erhöht werden.

Versieht man die Schaltung 3 mit einem zusätzlichen Pulsgenerator, so kann die an die Plasmakammer angelegte Spannung nicht nur beim Auftreten eines Arcs, sondern regelmäßig für einen kurzen Moment umgepolt werden. Hierdurch kann die Wahrscheinlichkeit für die Entstehung von Lichtbögen wesentlich verringert werden bzw. Lichtbögen können schon in der Entstehung wieder gelöscht werden.

Zusätzlich wird verhindert, daß sich beim reaktiven Sputtern Oxidschichten auf dem Target bilden; weiterhin können oxidierte Targets freigesputtert werden.

Fig. 5 zeigt schematisch den Spannungsverlauf für diese Modifikation des in Fig. 3 gezeigten Ausführungsbeispiels. Die Pulsfrequenzen können je nach verwendetem Leistungsschalter bis zu 100 kHz betragen.

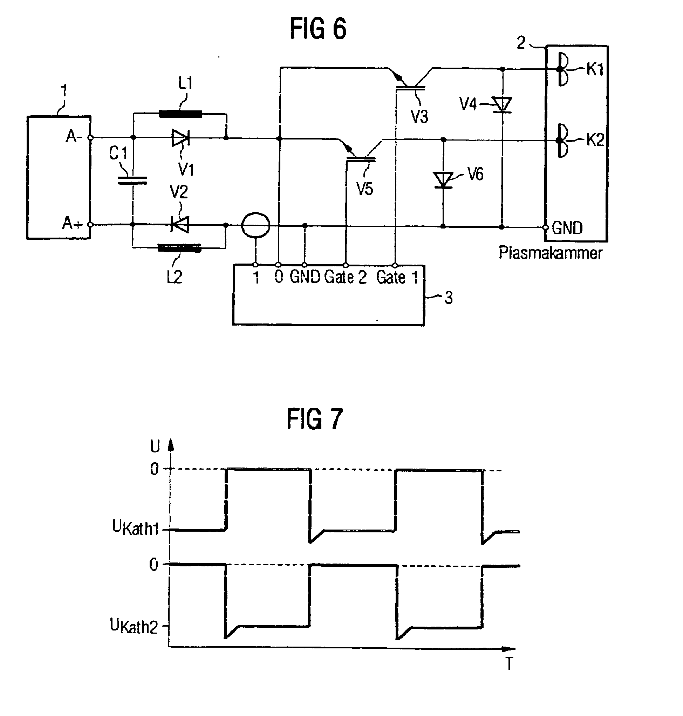

Fig. 6 zeigt die Schaltung eines weiteren Beispiels, bei der in der Plasmakammer 2 zwei Kathoden K1 und K2 angeordnet sind, denen jeweils eigene Leistungsschalter V3 und V5 und Dioden V4 und V6 zugeordnet sind.

Durch gleichzeitiges Einschalten der Leistungsschalter V3 und V5 arbeiten die beiden Kathoden im Parallelbetrieb. Werden die beiden Schalter abwechselnd eingeschaltet, kann durch Variationen der Einschaltzeiten die effektive Leistung der Kathoden geregelt werden. Es sind Umschaltfrequenzen bis zu mehreren kHz möglich.

Fig. 7 zeigt ein Spannungs/Zeit-Diagramm, in dem das alternierende Einschalten der beiden Schalter schematisch dargestellt ist. Selbstverständlich können auch mehr als zwei Kathoden eingesetzt werden.

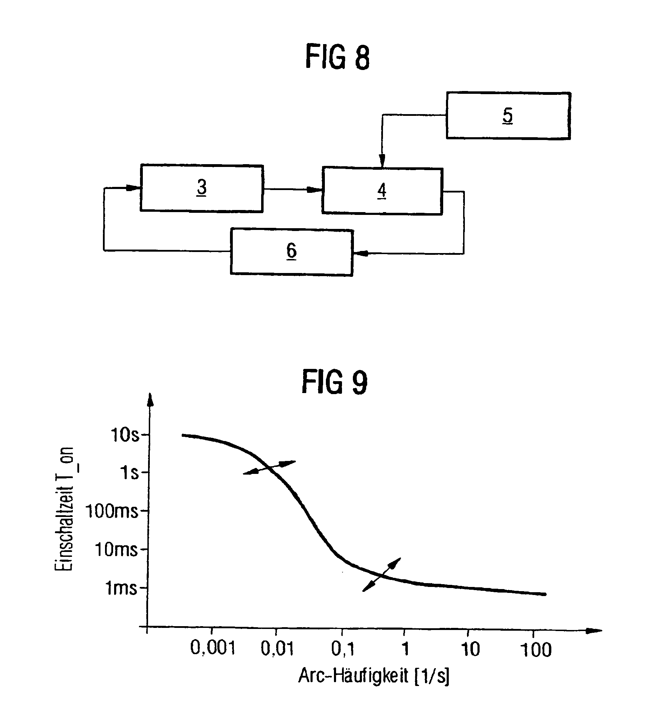

Fig. 8 zeigt ein Beispiel, bei dem die Leistungsminderung, die sich bei der Vorgehensweise gemäß Fig. 5 durch das prophylaktische Umschalten der Spannung mit einer festen, vorgegebenen Frequenz ergibt, deutlich reduziert wird:

Bei diesem Beispiel ist die Schaltung 3 durch eine adaptive Regeleinheit 4 mit einer Startwert-vorgabeeinheit 5 ergänzt.

Aufgrund der Verwendung einer adaptiven Regeleinheit 4 ist die Einschaltdauer der an die Elektroden angelegten Spannung nicht fest vorgegeben. Im laufenden Betrieb wird durch die adaptive Regeleinheit 4 eine möglichst hohe Einschaltdauer eingestellt, um den Plasmaprozeß in einer Plasmaanlage 6 nicht durch unnötige Austastung - wie gemäß Fig. 5 und 7 zu unterbrechen. Treten jedoch Arcs auf, so wird nach dem Löschen des Arcs die Einschaltdauer verkürzt. Damit wird die Wahrscheinlichkeit für das Auftreten eines wiederholten Arcs geringer. Tritt trotz der verkürzten Einschaltdauer weiterhin ein Arc auf, wird die Einschaltdauer weiter verkürzt, bis ein stabiler, Arc-freier Betrieb möglich ist. Entsprechend wird die Einschaltdauer verlängert, wenn über eine bestimmte Zeit keine Arcs aufgetreten sind. Die Einschaltdauer wird dann so lange verlängert, bis wiederum Arcs im Prozeß auftreten. Die Verlängerung der Einschaltdauer kann soweit gehen, daß die Anlage im "continous-Betrieb" (CW-Betrieb) gefahren wird.

Die Einschaltzeit und die Arc-Häufigkeit können über eine variable Kennlinie der adaptiven Regeleinheit, die von weiteren Prozeßparametern - Prozeßgase, Target- und Sputtermaterialien usw. - abhängig sein kann, miteinander verknüpft bzw. korreliert werden. Fig. 9 zeigt qualitativ eine Kennlinie, die die auf der Abzisse aufgetragene Arc-Häufigkeit (1/s) mit der auf der Ordinate aufgetragenen Einschaltzeit (s) korreliert. Ausdrücklich wird darauf hingewiesen, daß entsprechende Kennlinien nicht nur von mehreren Parametern, sondern auch von der Geometrie der Plasmaanlage, den Prozeßmaterialien usw. abhängen. Bevorzugt werden die Kennlinien empirisch ermittelt und/oder von der Regeleinheit 4, die beispielsweise einen Mikroprozessor aufweisen kann, adaptiv eingestellt.

Über die Startwert-Vorgabeeinheit 5 können bestimmte, als vorteilhaft erkannte Werte für die Einschaltdauer sowie die Aus- bzw. Umschaltdauer beim Beginn des Plasmabetriebs vorgegeben oder bestimmte bereits ermittelte Kennlinie gewählt werden.

Durch die Verwendung eines adaptiven Regelalgorithmus werden die Parameter des Arc-Managements an die Prozeßparameter optimal angepaßt. Dabei ist es insbesondere auch möglich, die Aus- bzw. Umschaltdauer optimal - gegebenenfalls auch adaptiv - einzustellen.

Die Erfindung ist vorstehend anhand von einem Ausführungsbeispiel ohne Beschränkung der Allgemeinheit beschrieben worden. Insbesondere kann die erfindungsgemäße Versorgungseinheit für alle aus der einleitend genannten Literatur bekannten Anwendungen eingesetzt werden. Weiterhin ist es möglich, den Pulsbetrieb oder die adaptive Regelung, die aktive Löschung von Lichtbögen und das Umschalten zwischen zwei oder mehr Kathoden teilweise oder vollständig miteinander zu kombinieren oder zwischen den einzelnen beschriebenen Betriebsmodi umzuschalten.

## Patentansprüche

1. Elektrische Versorgungseinheit für Plasmaanlagen, wie Plasma- Bearbeitungs- bzw. Beschichtungsvorrichtungen, bei denen es zum Auftreten von Lichtbögen bzw. Durchschlägen, sogenannten Arcs, kommen kann, mit einer Gleichspannungs- bzw. Gleichstromquelle mit einem negativen Ausgangsanschluß (A-) und einem positiven Ausgangsanschluß (A+), die über wenigstens eine mit einer Freilaufdiode (V1, V2) beschaltete Induktivität (L1,L2) und einen Leistungsschalter als Serienschalter (V3) mit den Elektroden der Plasmaanlage verbunden sind, **dadurch gekennzeichnet, dass** eine Diode (V4) derart in Reihe mit einem Kondensator (C2) geschaltet ist, dass die Anode der Diode in Richtung zum negativen Ausgangsanschluß (A-) gepolt ist und
der Kondensator (C2) geeignet ist, bei geöffnetem Schalter (V3) die sich aus Leitungsinduktivität und dem Strom ergebende Energie als Spannung durch Umladung aufzunehmen.

2. Elektrische Versorgungseinheit für Plasmaanlagen nach Anspruch 1,
weiter **dadurch gekennzeichnet, dass**
eine Schaltung zum Erkennen von Lichtbögen bzw. Durchschlägen (Arcs) vorgesehen ist, die beim Auftreten eines Lichtbogens bzw. Durchschlags (Arcs) den Schalter betätigt, und den Stromfluß zwischen der Gleichspannungsquelle und den Elektroden öffnet.

3. Elektrische Versorgungseinheit für Plasmaanlagen nach Anspruch 1 oder 2,
weiter **dadurch gekennzeichnet, dass**
ein LC-Glied parallel zur Diode (V4) geschaltet ist.

4. Elektrische Versorgungseinheit für Plasmaanlagen nach Anspruch 2 oder 3,
weiter **dadurch gekennzeichnet, dass**
die Schaltung zum Erkennen von Durchschlägen bzw. Lichtbogen (Arcs) wenigstens eines der folgenden Kriterien auswertet:
- Spannungseinbruch,
- Überschreiten der Maximum- Spannungsgrenze,
- Unterschreiten der Minimum- Spannungsgrenze
- Schneller Stromanstieg,
- Überschreiten der Maximum- Stromgrenze.

5. Elektrische Versorgungseinheit für Plasmaanlagen nach einem der Ansprüche 2 bis 4,
weiter **dadurch gekennzeichnet, dass**
eine Steuereinheit vorgesehen ist, die periodisch die an die Elektroden angelegte Spannung ab- und bevorzugt umschaltet.

6. Elektrische Versorgungseinheit für Plasmaanlagen nach einem der Ansprüche 1 bis 5,
weiter **dadurch gekennzeichnet, dass**
zwischen einem Anschluß einer Kathode (K) der Plasmaanlage und den Verbindungspunkt Diode (V4) / Kondensator (C2) ein weiterer Serienschalter (V5) geschaltet ist.

7. Elektrische Versorgungseinheit für Plasmaanlagen nach einem der Ansprüche 1 bis 6,
weiter **dadurch gekennzeichnet, dass**
eine Inversspannungsquelle vorgesehen ist.

8. Elektrische Versorgungseinheit für Plasmaanlagen nach Anspruch 7,
weiter **dadurch gekennzeichnet, dass**
die Spannung am Kondensator (C2) als Inversspannung zur Löschung des Lichtbogens an die Elektroden angelegt wird.

9. Elektrische Versorgungseinheit für Plasmaanlagen nach Anspruch 8,
weiter **dadurch gekennzeichnet, dass**
parallel zu dem Kondensator (C2) eine Hilfsspannungsquelle (U1) zur Erhöhung der Inversspannung geschaltet ist.

10. Verfahren zum Betrieb einer elektrischen Versorgungseinheit für Plasmaanlagen wie Plasmabearbeitungs- oder Beschichtungsvorrichtungen, bei denen es zum Auftreten von Lichtbögen oder Durchschlägen kommen kann, mit einer Gleichspannungs- bzw. Gleichstromquelle, deren Ausgangsanschlüsse (A-, A+) über wenigstens eine mit einer Freilaufdiode (V1,V2) beschaltete Induktivität (L1,L2) und einen Leistungsschalter (V3) mit den Elektroden der Plasmaanlage verbunden sind, wobei sich aus Leitungsinduktivität und Strom eine Energie ergibt, und wobei beim Erkennen eines Lichtbogens der Leistungsschalter den Stromfluss zwischen Gleichspannungs- bzw. Gleichstromquelle und Elektroden öffnet, wobei die Freilaufdiode, die bezogen auf die normale Betriebsspannung in Sperrrichtung gepolt ist, beim Öffnen des Leistungsschalters verhindert, dass die Spannung an der wenigstens einen Induktivität ansteigt,
**dadurch gekennzeichnet, dass**
beim Öffnen des Leistungsschalters durch einen mit einer mit ihrer Anode in Richtung zu dem negativen Ausgangsanschluß (A-) angeschlossenen Diode (V4) in Reihe geschalteten Kondensator (C2) die sich aus Leitungsinduktivität und dem Strom ergebende Energie als Spannung in den Kondensator (C2) umgeladen wird.

11. Verfahren zum Betrieb einer elektrischen Versorgungseinheit für Plasmaanlagen nach Anspruch 10,
weiter **dadurch gekennzeichnet, dass**
die sich aus der Leitungsindtiktivität und dem fließenden Strom ergebende Energie beim Öffnen des Leistungsschalters abgebaut wird.

12. Verfahren zum Betrieb einer elektrischen Versorgungseinheit für Plasmaanlagen nach Anspruch 10,
weiter **dadurch gekennzeichnet, dass**
nach einer kurzen Verzögerung die in den Kondensator umgeladene Spannung über einen weiteren Serienschalter (V5) an die Elektroden angelegt wird.

13. Verfahren zum Betrieb einer elektrischen Versorgungseinheit für Plasmaanlagen nach Anspruch 12,
weiter **dadurch gekennzeichnet, dass**
die Spannung des Kondensators als Inversspannung an die Plasmakammer angelegt wird.

14. Verfahren zum Betrieb einer elektrischen Versorgungseinheit für Plasmaanlagen nach Anspruch 13,
weiter **dadurch gekennzeichnet, dass** 1.
die Inversspannung durch eine Hilfsgleichspannungsquelle (U1) erhöht wird.

## Claims

1. An electric supply unit for plasma systems such as plasma-processing or plasma-coating apparatuses in which electric arcs or disruptive discharges, so-called arcs, may occur, comprising a DC voltage or DC current source with a negative output terminal (A-) and a positive output terminal (A+), which are connected to the electrodes of the plasma system via at least one inductance (L1, L2) connected to a freewheeling diode (V1, V2) and one power switch as a series switch (V3), **characterized in that** a diode (V4) is switched in series with a capacitor (C2) in such a way that the anode of the diode is poled in the direction towards the negative output terminal (A-), and the capacitor (C2) is capable, when the switch (V3) is open, to absorb by way of charge reversal the energy as voltage which results from the line inductivity and the current.

2. An electric supply unit for plasma systems according to claim 1, further **characterized in that** a circuit is provided for recognizing electric arcs or disruptive discharges (arcs), which circuit actuates the switch upon occurrence of an arc or disruptive discharge (arc), and opens the current flow between the direct current source and the electrodes.

3. An electric supply unit for plasma systems according to claim 1 or 2, further **characterized in that** an LC circuit is switched in parallel to the diode (V4).

4. An electric supply unit for plasma systems according to claim 2 or 3, further **characterized in that** the circuit for recognizing disruptive discharges or arcs evaluates at least one of the following criteria:
- a drop of voltage;
- exceeding the maximum voltage limit;
- falling short of the minimum voltage limit;
- rapid rise of current;
- exceeding the maximum current limit.

5. An electric supply unit for plasma systems according to one of the claims 2 to 4, further **characterized in that** a control unit is provided which periodically switches off, and preferably switches over, the voltage applied to the electrodes.

6. An electric supply unit for plasma systems according to one of the claims 1 to 5, further **characterized in that** a further series switch (V5) is connected between a contact of a Cathode (K) of the plasma system and the interconnection of diode (V4) / capacitor (C2).

7. An electric supply unit for plasma systems according to one of the claims 1 to 6, further **characterized in that** an inverse voltage source is provided.

8. An electric supply unit for plasma systems according to claim 7, further **characterized in that** the voltage at the capacitor (C2) is applied to the electrodes as an inverse voltage for quenching the arc.

9. An electric supply unit for plasma systems according to claim 8, further **characterized in that** an auxiliary voltage source (U1) is switched in parallel to the capacitor (C2) for increasing the inverse voltage.

10. A method for operating an electric supply unit for plasma system such as plasma-processing or plasma-coating apparatuses, in which electric arcs or disruptive discharges may occur, comprising a DC voltage or DC current source whose output terminals (A-, A+) are connected to the electrodes of the plasma system via at least one inductance (L1, L2) connected to a freewheeling diode (V1, V2) and one power switch (V3), wherein energy is obtained from the line inductivity and current, and wherein upon recognizing an arc the power switch opens the current flow between the DC voltage or DC current source and the electrodes, wherein the freewheeling diode, which is poled in the non-conducting direction relating to the normal operating voltage, prevents during opening of the power switch that the voltage will rise in the at least one inductance, **characterized in that** the energy resulting from the line inductivity and the current is transferred as voltage to the capacitor (C2) during the opening of the power switch by a capacitor (C2) connected in series with a diode (V4) which is connected with its anode in the direction towards the negative output terminal (A-).

11. A method for operating an electric supply unit for plasma systems according to claim 10, further **characterized in that** the energy resulting from the line inductivity and the flowing current is dissipated during the opening of the power switch.

12. A method for operating an electric supply unit for plasma systems according to claim 10, further **characterized in that** after a brief delay the voltage transferred to the capacitor is applied via a further series switch (V5) to the electrodes.

13. A method for operating an electric supply unit for plasma systems according to claim 12, further **characterized in that** the voltage of the capacitor is applied as an inverse voltage to the plasma chamber.

14. A method for operating an electric supply unit for plasma systems according to claim 13, further **characterized in that** the inverse voltage is increased by an auxiliary DC voltage source (U1).

## Revendications

1. Unité électrique d'alimentation pour des installations à plasma telles que des dispositifs de traitement ou de revêtement à plasma, dans lesquelles des arcs électriques ou des décharges peuvent se produire entre les électrodes, avec une source de tension continue ou de courant continu ayant une connexion de sortie négative (A-) et une connexion de sortie positive (A+) qui sont reliées aux électrodes de l'installation à plasma par l'intermédiaire d'au moins une inductance (L1, L2) montée avec une diode de roue libre (V1, V2) et d'un disjoncteur de puissance formant un disjoncteur en série (V3),
**caractérisée en ce qu'**une diode (V4) est montée en série avec un condensateur (C2) de telle manière que son anode soit polarisée en direction de la connexion de sortie négative (A-) et
**en ce que** le condensateur (C2) est adapté pour absorber, quand le disjoncteur (V3) est ouvert, l'énergie résultant de l'inductance de puissance et de l'intensité sous forme de tension, par transfert de charge.

2. Unité électrique d'alimentation pour installations à plasma selon la revendication 1, **caractérisée en outre en ce qu'**un circuit est prévu pour détecter les arcs électriques ou décharges, lequel actionne le disjoncteur en cas d'apparition d'un arc électrique ou d'une décharge et ouvre l'écoulement du courant entre la source de courant continu et les électrodes.

3. Unité électrique d'alimentation pour installations à plasma selon la revendication 1 ou 2, **caractérisée en outre en ce qu'**un circuit LC est monté en parallèle avec la diode (V4).

4. Unité électrique d'alimentation pour installations à plasma selon la revendication 2 ou 3, **caractérisée en outre en ce que** le circuit pour la détection des décharges ou des arcs électriques analyse au moins un des critères suivants :
- baisse de tension,
- dépassement de la limite de tension maximale,
- passage en dessous de la limite de tension minimale,
- élévation rapide de l'intensité,
- dépassement de la limite d'intensité maximale.

5. Unité électrique d'alimentation pour installations à plasma selon l'une des revendications 2 à 4, **caractérisée en outre en ce qu'**il est prévu une unité de commande qui coupe et de préférence commute périodiquement la tension appliquée aux électrodes.

6. Unité électrique d'alimentation pour installations à plasma selon l'une des revendications 1 à 5, **caractérisée en outre en ce qu'**un autre disjoncteur en série (V5) est monté entre la connexion de sortie négative (A-) et le point de connexion entre la diode (V4) et le condensateur (C2).

7. Unité électrique d'alimentation pour installations à plasma selon l'une des revendications 1 à 6, caractérisée en ce outre en ce qu'une source de tension inversée est prévue.

8. Unité électrique d'alimentation pour installations à plasma selon la revendication 7, **caractérisée en outre en ce que** la tension est appliquée au niveau du condensateur (C2) sous forme de tension inversée pour éteindre l'arc électrique au niveau des électrodes.

9. Unité électrique d'alimentation pour installations à plasma selon la revendication 8, caractérisée en ce outre en ce qu'une source de tension auxiliaire (U1) est montée en parallèle avec le condensateur (C2) pour élever la tension inversée.

10. Procédé pour faire fonctionner une installation électrique d'alimentation pour des installations à plasma telles que des dispositifs de traitement ou de revêtement à plasma, dans lesquelles des arcs électriques ou des décharges peuvent se produire entre les électrodes, avec une source de tension continue ou de courant continu dont les connexions de sortie (A-, A+) sont reliées aux électrodes de l'installation à plasma par l'intermédiaire d'au moins une inductance (L1, L2) montée avec une diode de roue libre (V1, V2) et d'un disjoncteur de puissance (V3), l'inductance de ligne et l'intensité donnant une énergie et le disjoncteur de puissance ouvrant, lorsqu'un arc électrique est détecté, l'écoulement du courant entre la source de tension continue ou de courant continu et les électrodes, la diode de roue libre, qui est polarisée dans le sens bloquant par rapport à la tension de service normale, empêchant l'augmentation de la tension au niveau de l'au moins une inductance lors de l'ouverture du disjoncteur de puissance,
**caractérisé en ce que** lors de l'ouverture du disjoncteur de puissance par un condensateur (C2) monté en série avec une diode (V4) raccordée par son anode en direction de la connexion de sortie négative (A-), l'énergie résultant de l'inductance de ligne et de l'intensité est transférée sous forme de tension dans le condensateur (C2).

11. Procédé pour faire fonctionner une installation électrique d'alimentation pour des installations à plasma selon la revendication 10, **caractérisé en outre en ce que** l'énergie résultant de l'inductance de ligne et du courant circulant est réduite lors de l'ouverture du disjoncteur de puissance.

12. Procédé pour faire fonctionner une installation électrique d'alimentation pour des installations à plasma selon la revendication 10, **caractérisé en outre en ce qu'**après un court temps d'attente, la tension transférée dans le condensateur est appliquée aux électrodes par l'intermédiaire d'un autre disjoncteur en série (V5).

13. Procédé pour faire fonctionner une installation électrique d'alimentation pour des installations à plasma selon la revendication 12, **caractérisé en outre en ce que** la tension du condensateur est appliquée sous forme de tension inversée dans la chambre à plasma.

14. Procédé pour faire fonctionner une installation électrique d'alimentation pour des installations à plasma selon la revendication 13, **caractérisé en outre en ce que** la tension inversée est élevée par une source de tension continue auxiliaire (U1).
